# EUROPEAN PATENT SPECIFICATION

(11) **EP 3 239 984 B1**
(45) Date of publication and mention of the grant of the patent: **01.01.2020**
(21) Application number: 17165233.2
(22) Date of filing: 06.04.2017
(51) Int. Cl.: G11C 29/00, G11C 29/44, G11C 5/04, G06F 11/10, G11C 29/04, G11C 29/08

(54) **METHODS AND SYSTEMS FOR ANALYZING RECORD AND USAGE IN POST PACKAGE REPAIR**
VERFAHREN UND SYSTEME ZUR ANALYSE DER AUFZEICHNUNG UND NUTZUNG BEI DER POSTPAKETREPARATUR
PROCÉDÉS ET SYSTÈMES D'ANALYSE D'ENREGISTREMENT ET D'UTILISATION DANS UNE RÉPARATION POST-CONDITIONNEMENT

(30) Priority: 26.04.2016 US 201615138865
(43) Date of publication of application: 01.11.2017
(73) Proprietor: Quanta Computer Inc., Tao Yuan Shien (TW)
(72) Inventor: Wu, Feng-Chou, Tao Yuan Shien (TW)
(74) Representative: Michalski Hüttermann & Partner Patentanwälte mbB

(56) References cited:
- WO-A1-2015/199700
- US-A1- 2010 085 825
- US-A1- 2013 182 489
- US-A1- 2014 223 032
- US-A1- 2015 067 100
- US-B1- 9 043 638

## Description

### TECHNICAL FIELD

The present technology relates generally to server systems in a telecommunications network.

### BACKGROUND

PPR (Post Package Repair) is a feature in double data rate (DDR) Fourth Generation synchronous dynamic random-access memory (SDRAM). PPR provides a mechanism to repair memory defect(s) using available spare row(s) in bank group(s) of the SDRAM. However, PPR is a permanent repair and cannot be reversed once repaired. Therefore, there is a need to enhance the PPR feature in a DDR4 SDRAM, such as WO 2015/199700 A1, which provides a post package repair (PPR) data in non-volatile memory on a memory module. In addition, US 2010/0085825 A1 provides a memory device having multiple dice arranged in a stack in which a defective cell may be replaced by a spare cell on the same die or a different die.

### SUMMARY

The invention is addressed by the subject matter of the independent claims. Preferred embodiments are described in the sub claims. Systems and methods in accordance with various embodiments of the present technology provide a solution to the above-mentioned problems in a server system by tracking and managing a plurality of bank groups of a memory module (e.g., a dual in-line memory module (DIMM)) that support post package repair (PPR). More specifically, various embodiments of the present technology provide methods for tracking PPR usage in each DIMM of a server system. BIOS of the server system can check a record of the PPR usage before conduct a PPR flow. In response to determining that all spare row(s) of a target bank group has been consumed, the BIOS can skip the ineffective repair action and then save power-on self-test (POST) for a predetermined period of time (e.g., 2 seconds) per ineffective repair action. The BIOS can also send the usage status of the target bank to a controller (e.g., BMC) of the server system such that a user or the server system can check PPR status of each DIMM of the server system. A determination can be made either automatically by the server system or manually by the user whether or not to replace a corresponding DIMM. In some implementations, intelligent platform management interface (IPMI) commands (CMDs) can be used by a user to check status of each DIMM's PPR.

In conventional server systems, a DDR4 SDRAM does not provide any register for a user to check status of a plurality of bank groups of a SDRAM. A user or a server system does not know how many bank groups that have extra capacities for PPR. In contrast, various embodiments of the present technology provide a faster and more cost-efficient method to manage PPR usage status of a SDRAM and provide an option for a user or a server system to review PPR status of a dual in-line memory module (DIMM) (e.g., a DDR4 SDRAM module) and make a determination whether to replace the DIMM.

In some embodiments, PPR status of a DIMM can be stored in a specific storage. For example, the PPR status can be stored in a DDR4 serial presence detect (SPD) module, a BIOS variable module, or a controller (e.g., baseboard management controller (BMC) or rack management controller (RMC)). In some implementations, the DDR SPD module can operate independently from a BIOS or a controller of a corresponding server system such that PPR status stored in the DDR SPD module is also independent from the BIOS or the controller.

In some embodiments, one or more "End User Programmable" regions of a DDR4 SPD module can be used to store PPR status. The PPR status can include status of a first subset of a plurality of bank groups in a corresponding DIMM and status of a second subset of the plurality of bank groups. A bank group in the first subset of the plurality bank groups has at least one spare row that hasn't been used. A bank group in the second subset of the plurality bank groups has no spare row that hasn't been used. In some embodiments, before executing any PPR repair, BIOS of a server system can retrieve a PPR status from the SPD module. The PPR status includes information of the first subset bank groups and the second subset bank groups. In response to determining that the first subset of the plurality of bank groups comprises at least one bank group having spare row(s), the BIOS can run the PPR repair and then update the PPR status stored in the SPD module.

In response to determining that there is no bank group in the first subset of the plurality of bank groups, the BIOS can skip the PPR repair. In some embodiments, in response to determining that there is no spare row in the plurality of bank groups, the BIOS can skip the PPR repair. When a memory error occurs, the BIOS can log physical location address(es) of the memory error in a memory mask table. The corresponding address(es) can then be masked during a subsequent POST.

### BRIEF DESCRIPTION OF THE DRAWINGS

In order to describe the manner in which the above-recited and other advantages and features of the disclosure can be obtained, a more particular description of the principles briefly described above will be rendered by reference to specific examples thereof which are illustrated in the appended drawings. Understanding that these drawings depict only example aspects of the disclosure and are not therefore to be considered to be limiting of its scope, the principles herein are described and explained with additional specificity and detail through the use of the accompanying drawings in which:
FIG. 1A illustrates a schematic block diagram of an exemplary server rack in a network in accordance with an embodiment of the present technology;
FIG. 1B illustrates a schematic block diagram of an exemplary PPR status table in a SPD module of a DIMM in accordance with an embodiment of the present technology;
FIG. 1C illustrates a schematic block diagram of an exemplary server system in accordance with an embodiment of the present technology;
FIG. 2A illustrates an exemplary method of a PPR repair in accordance with an embodiment of the present technology;
FIG. 2B illustrates an exemplary method of managing a PPR status table in a server system in accordance with an embodiment of the present technology;
FIG. 3 illustrates an exemplary computing device in accordance with various implementations of the technology; and
FIGs. 4 and 5 illustrate exemplary systems in accordance with various embodiments of the present technology;

### DETAILED DESCRIPTION

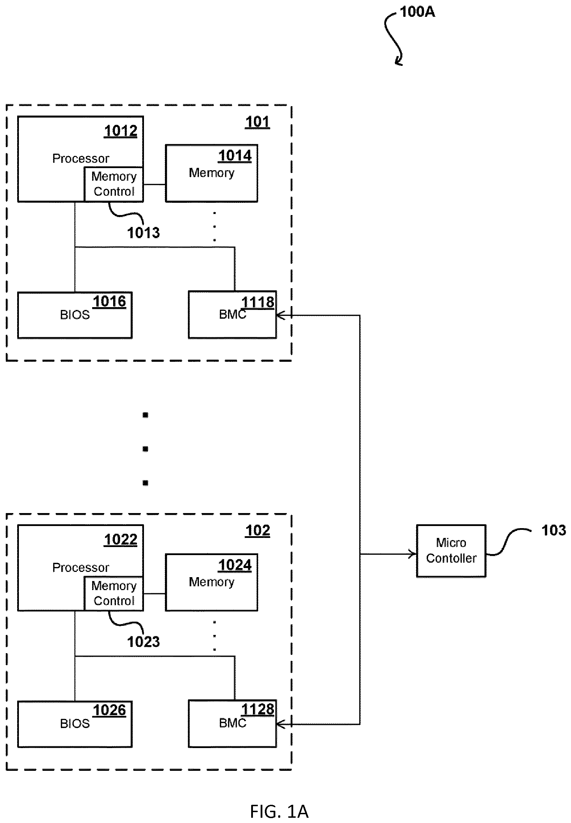

FIG. 1A illustrates a schematic block diagram of an exemplary server rack 100A in a network in accordance with an embodiment of the present technology. In this example, the server rack 100A comprises a plurality of nodes (e.g., server systems 101 and 102) and a micro controller 103 (e.g., a RMC). Each of the plurality nodes may comprise a processor (e.g., 1012 or 1022), a BIOS (e.g., 1016 or 1026), a BMC (e.g., 1118 or 1128), and a memory (e.g., 1014 or 1024). The plurality of nodes can operate independently from each other. In some implementations, the plurality of nodes can have a similar computing capacity and similar memory capacity. In other implementations, the plurality of nodes can have various different sizes, computing capacities and memory capacities.

In this example, the BIOS (e.g., 1016 or 1026) and the BMC (e.g., 1118 or 1128) are coupled to the memory (e.g., 1014 or 1024) through the processor (e.g., 1012 or 1022). The BIOS or BMC can access or manage the memory through a memory control module (e.g., 1013 or 1023) of the processor.

In some implementations, the BIOS is software stored in a read-only memory (ROM) or other stored devices. The BIOS 104 can provide an abstraction layer for hardware components, application programs, and operating systems to interact with input/output devices (e.g., keyboard, display). In some embodiments, an operating system can ignore an abstraction layer provided by the BIOS and access hardware components of the corresponding node or the plurality of nodes directly after loading.

In some embodiments, the memory (e.g., 1014 or 1024) is one or more DIMMs (e.g., a SDRAM module or DDR SDRAM comprising a SPD module). The SPD module can operate independently from the BIOS and BMC of a corresponding node and be used to store PPR status of a corresponding DIMM. For example, "End User Programmable" region(s) of a SPD can be used to store the PPR status.

The BIOS or BMC can track PPR usage of a DIMM stored in a corresponding SPD module. In response to determining that a target bank of a plurality of bank group of the DIMM has no spare row left, the BIOS or BMC can perform PPR repair and then update the PPR status stored in the SPD module.

In response to determining that a target bank of a plurality of bank group of the DIMM has no spare row left, the BIOS or BMC can skip the repair action of the PPR and then send out a usage status of the target bank of the DIMM. The BMC can automatically check PPR status of each DIMM in a corresponding node. In response to determining that no spare row remains in a DIMM, the BMC can send out a notification to a user of the node to replace the DIMM.

Table 1 illustrates an exemplary PPR status table in accordance with an implementation of the present technology. In this example, 128 bytes are reserved for "End User Programmable" regions of a DDR4 SPD of a DIMM. A bit map format can be used to record PPR status of a plurality of bank groups of the DIMM. In some embodiments, information of the DIMM can be fetched from other regions of the DDR4 SPD and used to determine a number of bank groups in the DIMM. In response to determining that a PPR repair has never been conducted on the DIMM, the BIOS or BMC can build a new PPR status table and write the table to the SPD.

**Table 1: An example PPR status table.**

| Field | Byte Length | Byte Offset | Description |
|---|---|---|---|
| Signature | 3 | 0 | "PPR" Signature for the table. |
| Length | 1 | 3 | Length, in bytes, of the table. |
| Checksum | 1 | 4 | Entire table must sum to zero. |
| PPR status | -- | s | Bit Map for hard PPR Record. |
| | | | Lower Nibble of Byte 6 for Rank0.Dev0: |
| | | | Bit [0]: Bank Group 0 |
| | | | 0 = PPR available, 1 = PPR done. |
| | | | Bit [1]: Bank Group 1 |
| | | | Bit [2]: Bank Group 2 (reserved for x16 DIMM) |
| | | | Bit [3]; Bank Group 3 (reserved for x16 DIMM) |
| | | | Upper Nibble of Byte 6 for Rank0,Dev1 |
| | | | Lower Nibble of Byte 7 for Rank0,Dev2 |
| | | | Upper Nibble of Byte 7 for Rank0,Dev3 |
| | | | ...and so on |

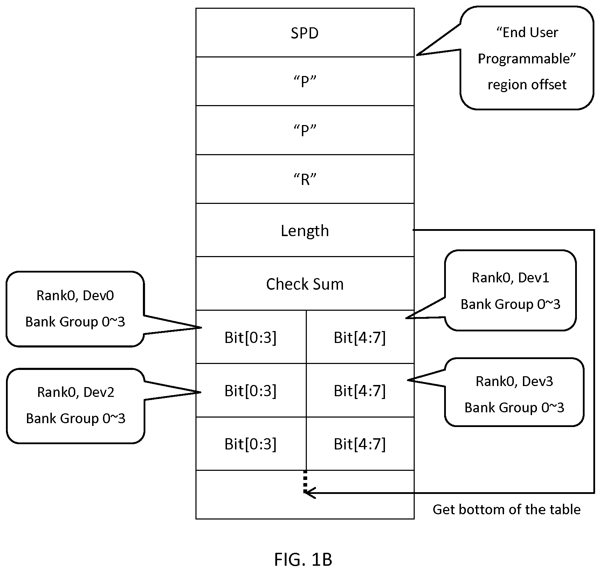

In this example, a header of a PPR status table includes a "Signature" field for identification, a "Length" field for describing a total size of the table, and a "Checksum" field for checking whether data is correct or not. Following the header, the PPR status table contains information describing PPR status of each of a plurality of bank groups in the DIMM. For example, 4 bits can be used to describe PPR status for back group 0 to 3 in the DIMM. An example of the PPR status table stored in the SPD is illustrated in FIG. 1B in accordance with an implementation of the present technology.

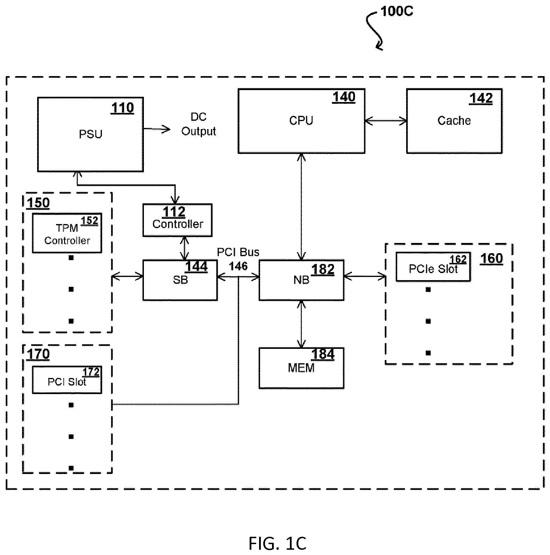

FIG. 1C illustrates a schematic block diagram of an exemplary server system 100C in accordance with an implementation of the present technology. In this example, the server system 100C comprises at least one microprocessor or CPU 140 connected to a Cache 142, a main Memory 184, and one or more PSUs 110 that provides power to the server system 100C. The main Memory 184 can be coupled to the CPU 140 via a north bridge (NB) logic 182. A memory control module (not shown) can be used to control operations of the Memory 184 by asserting necessary control signals during memory operations. The main Memory 184 may include, but is not limited to, DRAM, SDRAM, DDR DRAM, static RAM (SRAM), or other types of suitable memory.

In some implementations, the CPU 140 can be multi-core processors, each of which is coupled together through a CPU bus connected to the NB logic 182. In some implementations, the NB logic 182 can be integrated into the CPU 140. The NB logic 182 can also be connected to a plurality of peripheral component interconnect express (PCIe) ports 160 and a south bridge (SB) logic 144 (optional). The plurality of PCIe ports 160 can be used for connections and buses such as PCI Express x1, USB 2.0, SMBus, SIM card, future extension for another PCIe lane, 1.5 V and 3.3 V power, and wires to diagnostics LEDs on the server's chassis.

In this example, the NB logic 182 and the SB logic 144 are connected by a peripheral component interconnect (PCI) Bus 146. A PCI Bus can support function on the CPU 140 but in a preferably standardized format that is independent of any of CPU's native buses. The PCI Bus 146 can be further connected to a plurality of PCI slots 170 (e.g., a PCI Slot 172). Devices connected to the PCI Bus 146 may appear to a bus controller (not shown) to be connected directly to a CPU bus, assigned addresses in the CPU 140's address space, and synchronized to a single bus clock. PCI cards can be used in the plurality of PCI slots 170 include, but are not limited to, network interface cards (NICs), sound cards, modems, TV tuner cards, disk controllers, video cards, small computer system interface (SCSI) adapters, and personal computer memory card international association (PCMCIA) cards.

The SB logic 144 can couple the PCI Bus 146 to a plurality of peripheral IO devices 150 (e.g., a TPM controller 152) via an expansion bus. The expansion bus can be a bus used for communications between the SB logic 144 and peripheral devices, and may include, but is not limited to, an industry standard architecture (ISA) bus, PC/104 bus, low pin count bus, extended ISA (EISA) bus, universal serial bus (USB), integrated drive electronics (IDE) bus, or any other suitable bus that can be used for data communications for peripheral devices.

In the example, the SB logic 144 is further coupled to a controller 112 that is connected to the one or more PSUs 110. The one or more PSUs 110 are configured to supply powers to various component of the server system 100C, such as the CPU 140, Cache 142, NB logic 182, PCIe slots 160, Memory 184, SB logic 144, peripheral IO devices 150, PCI slots 170, and controller 112. After being powered on, the server system 100C is configured to load software application from memory, computer storage device, or an external storage device to perform various operations.

In some implementations, the controller 112 can be a baseboard management controller (BMC), rack management controller (RMC), a keyboard controller, or any other suitable type of system controller. In some embodiments, the controller 112 can be configured to control operations of the server system 100C and/or communicate with an administrator over a network.

In some implementations, the controller 112 can collect parameters (e.g., temperature, cooling fan speeds, power status, memory and/or operating system (OS) status) from different types of sensors that are built into the server system 100C. In some implementations, the controller 112 can also be configured to take appropriate action when necessary. For example, in response to any parameter on the different types of sensors that are built into the server system 100C going beyond preset limits, which can indicate a potential failure of the server system 100C, the controller 112 can be configured to perform a suitable operation in response to the potential failure. The suitable operation can include, but is not limited to, sending an alert to the CPU 140 or a system administrator over a network, or taking some corrective action such as resetting or power cycling the node to get a hung OS running again).

Although only certain components are shown within the server system 100C in FIG. 1C and the rack system 100A in FIG. 1A, various types of electronic or computing components that are capable of processing or storing data, or receiving or transmitting signals can also be included in the server system 100C in FIG. 1C and the rack system 100A in FIG. 1A. Further, the electronic or computing components in the server system 100C in FIG. 1C and the rack system 100A in FIG. 1A can be configured to execute various types of application and/or can use various types of operating systems. These operating systems can include, but are not limited to, Android, Berkeley Software Distribution (BSD), iPhone OS (iOS), Linux, OS X, Unix-like Real-time Operating System (e.g., QNX), Microsoft Windows, Window Phone, and IBM z/OS.

Depending on the desired implementation for the server system 100C in FIG. 1C and the rack system 100A in FIG. 1A, a variety of networking and messaging protocols can be used, including but not limited to TCP/IP, open systems interconnection (OSI), file transfer protocol (FTP), universal plug and play (UPnP), network file system (NFS), common internet file system (CIFS), AppleTalk etc. As would be appreciated by those skilled in the art, the server system 100C in FIG. 1C and the rack system 100A in FIG. 1A are used for purposes of explanation. Therefore, a network system can be implemented with many variations, as appropriate, yet still provide a configuration of network platform in accordance with various embodiments of the present technology.

In exemplary configuration of FIG. 1C and FIG. 1A, the server system 100C in FIG. 1C and the rack system 100A in FIG. 1A can also include one or more wireless components operable to communicate with one or more electronic devices within a computing range of the particular wireless channel. The wireless channel can be any appropriate channel used to enable devices to communicate wirelessly, such as Bluetooth, cellular, NFC, or Wi-Fi channels. It should be understood that the device can have one or more conventional wired communications connections, as known in the art. Various other elements and/or combinations are possible as well within the scope of various embodiments.

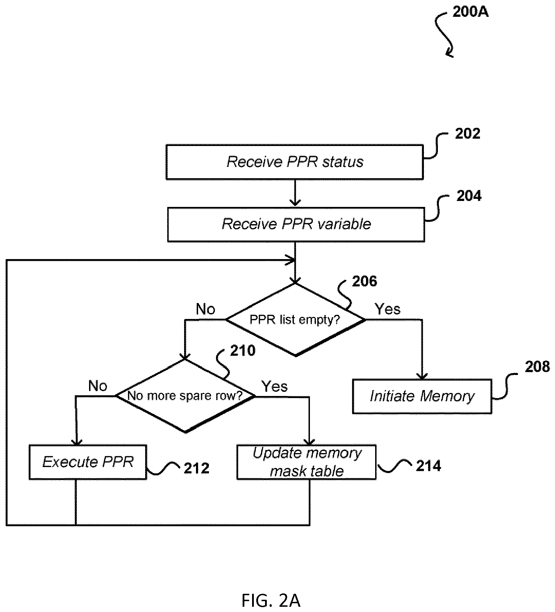

FIG. 2A illustrates an exemplary method 200A of a PPR repair in accordance with an embodiment of the present technology. It should be understood that the exemplary method 200A is presented solely for illustrative purposes and that in other methods in accordance with the present technology can include additional, fewer, or alternative steps performed in similar or alternative orders, or in parallel.

The exemplary method 200A starts with receiving PPR status of a DIMM from a specific storage of a server system (e.g., a DDR4 SPD of the DIMM, a BIOS variable module, or a controller of the server system), at step 202. In some embodiments, BIOS or a controller (e.g., a BMC) of the server system can receive the PPR status from the SPD via a memory controller of a processor, as illustrated in FIG. 1A and FIG. 1C. The SPD can operate independently from the controller. In some implementations, "End User Programmable" region(s) of the SPD can be used to store PPR the PPR status.

The PPR status may include a status of a plurality of bank groups of the corresponding DIMM, which includes a status of a first subset of the plurality of bank groups that has at least one spare row, and a status of a second subset of the plurality of bank groups that has no spare row.

At step 204, the BIOS can receive PPR variables from the specific storage. The PPR variables include a list of address location information of CPU, channel, DIMM, rank, device, bankgroup, bank or row that had memory error before. BIOS can use the PPR variable to test a target memory location and determine whether to trigger a PPR action or not.

At step 206, the BIOS or the controller can determine whether a PPR list is empty. In response to determining that the PPR list is empty, the BIOS or the controller can initiate memory (e.g., the corresponding DIMM) of the server system, at step 208.

At step 210, in response to determining that the PPR list is not empty and there is a memory error to be fixed, the BIOS or the controller can determine whether or not there is any spare row in a plurality of bank groups of the corresponding DIMM based at least upon the PPR status of the DIMM and the plurality of PPR variables. If the plurality of bank groups has no more spare row remaining, the BIOS or the controller can update a memory mask table of the server system and mask physical address(es) of the DIMM corresponding to the memory error. The process 200A then goes back to step 206.

If there is a memory error in the plurality of bank groups and the plurality of bank groups has at least one spare row, the BIOS or the controller can run the PPR and repair the memory error using the at least one spare row, at step 212. The BIOS or the controller may further update the PPR status stored in the specific storage of the server system. The process 200A then goes back to step 206.

If there is a memory error in the plurality of bank groups and there is no spare row in the plurality of bank groups, the BIOS or the controller can mask the memory error and update a memory mask table, at step 214.

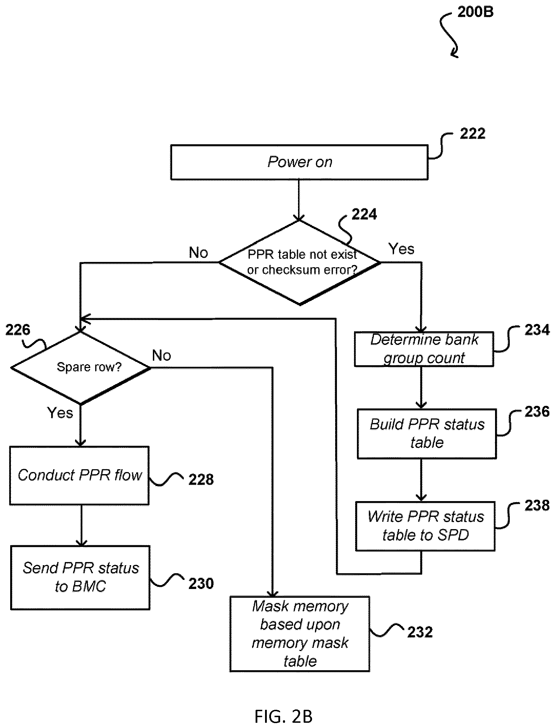

FIG. 2B illustrates an exemplary method 200B of managing a PPR status table in a server system in accordance with an embodiment of the present technology. The exemplary method 200B starts with powering on the server system, at step 222. BIOS or a controller of the server system can then check whether a PPR table does not exist or there is a checksum error, at step 224. An example of the PPR table is illustrated in FIG. 1B.

At step 226, in response to determining that the PPR table exists or there is no checksum error, the BIOS or the controller can further determine whether a plurality of bank groups of a corresponding DIMM has any spare row. At step 228, in response to determining that the plurality of bank groups has at least one spare row, the BIOS or the controller can conduct a PPR flow to repair a detected memory error, as illustrated in FIG. 1A, FIG. 1B and FIG. 1C. At step 230, the BIOS or the controller can then send a PPR status to a controller (e.g., BMC) of the server system, as illustrated in FIG. 1A, FIG. 1B and FIG. 1C. For example, the PPR flow can include repairing memory location(s) of the detected memory error with the at least one spare row based upon the PPR status table. In response to determining that there is no spare row with the plurality of bank groups, the BIOS or the controller can mask memory locations(s) of the detected memory error based upon a memory mask table of the DIMM or a memory of the server system, at step 232.

At step 234, in response to determining that the PPR table does not exist or there is checksum error, the BIOS or the controller can determine a count of the plurality of bank groups in a DIMM based at least upon information or status of the DIMM collected from non-SPD regions of the DIMM. At step 236, the BIOS or the controller can then generate a PPR status table based at least upon the count of the plurality of bank groups in the DIMM and PPR variables. At step 238, the BIOS or the controller can write the PPR status table to a SPD module of the DIMM. The process 200B then goes to step 226.

### Terminologies

A computer network is a geographically distributed collection of nodes interconnected by communication links and segments for transporting data between endpoints, such as personal computers and workstations. Many types of networks are available, with the types ranging from local area networks (LANs) and wide area networks (WANs) to overlay and software-defined networks, such as virtual extensible local area networks (VXLANs).

LANs typically connect nodes over dedicated private communications links located in the same general physical location, such as a building or campus. WANs, on the other hand, typically connect geographically dispersed nodes over long-distance communications links, such as common carrier telephone lines, optical lightpaths, synchronous optical networks (SONET), or synchronous digital hierarchy (SDH) links. LANs and WANs can include layer 2 (L2) and/or layer 3 (L3) networks and devices.

The Internet is an example of a WAN that connects disparate networks throughout the world, providing global communication between nodes on various networks. The nodes typically communicate over the network by exchanging discrete frames or packets of data according to predefined protocols, such as the Transmission Control Protocol/Internet Protocol (TCP/IP). In this context, a protocol can refer to a set of rules defining how the nodes interact with each other. Computer networks can be further interconnected by an intermediate network node, such as a router, to extend the effective "size" of each network.

Overlay networks generally allow virtual networks to be created and layered over a physical network infrastructure. Overlay network protocols, such as Virtual Extensible LAN (VXLAN), Network Virtualization using Generic Routing Encapsulation (NVGRE), Network Virtualization Overlays (NVO3), and Stateless Transport Tunneling (STT), provide a traffic encapsulation scheme which allows network traffic to be carried across L2 and L3 networks over a logical tunnel. Such logical tunnels can be originated and terminated through virtual tunnel end points (VTEPs).

Moreover, overlay networks can include virtual segments, such as VXLAN segments in a VXLAN overlay network, which can include virtual L2 and/or L3 overlay networks over which VMs communicate. The virtual segments can be identified through a virtual network identifier (VNI), such as a VXLAN network identifier, which can specifically identify an associated virtual segment or domain.

Network virtualization allows hardware and software resources to be combined in a virtual network. For example, network virtualization can allow multiple numbers of VMs to be attached to the physical network via respective virtual LANs (VLANs). The VMs can be grouped according to their respective VLAN, and can communicate with other VMs as well as other devices on the internal or external network.

Network segments, such as physical or virtual segments, networks, devices, ports, physical or logical links, and/or traffic in general can be grouped into a bridge or flood domain. A bridge domain or flood domain can represent a broadcast domain, such as an L2 broadcast domain. A bridge domain or flood domain can include a single subnet, but can also include multiple subnets. Moreover, a bridge domain can be associated with a bridge domain interface on a network device, such as a switch. A bridge domain interface can be a logical interface which supports traffic between an L2 bridged network and an L3 routed network. In addition, a bridge domain interface can support internet protocol (IP) termination, VPN termination, address resolution handling, MAC addressing, etc. Both bridge domains and bridge domain interfaces can be identified by a same index or identifier.

Furthermore, endpoint groups (EPGs) can be used in a network for mapping applications to the network. In particular, EPGs can use a grouping of application endpoints in a network to apply connectivity and policy to the group of applications. EPGs can act as a container for buckets or collections of applications, or application components, and tiers for implementing forwarding and policy logic. EPGs also allow separation of network policy, security, and forwarding from addressing by instead using logical application boundaries.

Cloud computing can also be provided in one or more networks to provide computing services using shared resources. Cloud computing can generally include Internet-based computing in which computing resources are dynamically provisioned and allocated to client or user computers or other devices on-demand, from a collection of resources available via the network (e.g., "the cloud"). Cloud computing resources, for example, can include any type of resource, such as computing, storage, and network devices, virtual machines (VMs), etc. For instance, resources can include service devices (firewalls, deep packet inspectors, traffic monitors, load balancers, etc.), compute/processing devices (servers, CPU's, memory, brute force processing capability), storage devices (e.g., network attached storages, storage area network devices), etc. In addition, such resources can be used to support virtual networks, virtual machines (VM), databases, applications (Apps), etc.

Cloud computing resources can include a "private cloud," a "public cloud," and/or a "hybrid cloud." A "hybrid cloud" can be a cloud infrastructure composed of two or more clouds that inter-operate or federate through technology. In essence, a hybrid cloud is an interaction between private and public clouds where a private cloud joins a public cloud and utilizes public cloud resources in a secure and scalable manner. Cloud computing resources can also be provisioned via virtual networks in an overlay network, such as a VXLAN.

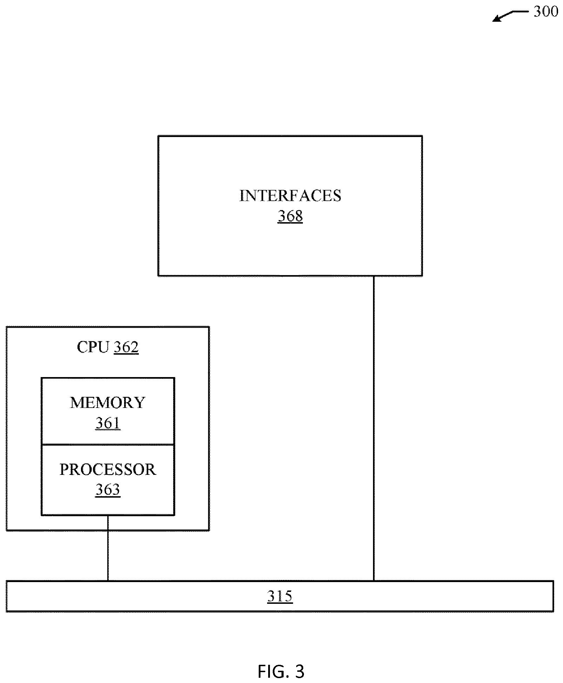

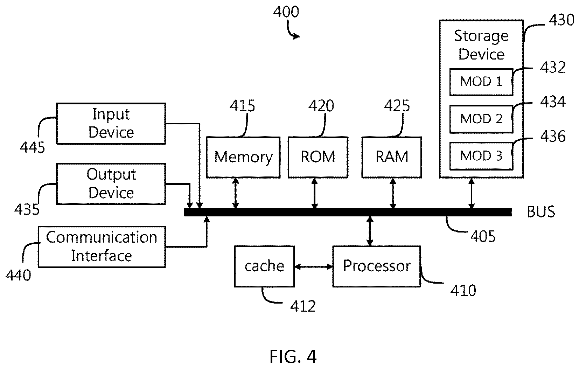

In a network switch system, a lookup database can be maintained to keep track of routes between a number of end points attached to the switch system. However, end points can have various configurations and are associated with numerous tenants. These end-points can have various types of identifiers, e.g., IPv4, IPv6, or Layer-2. The lookup database has to be configured in different modes to handle different types of end-point identifiers. Some capacity of the lookup database is carved out to deal with different address types of incoming packets. Further, the lookup database on the network switch system is typically limited by 1K virtual routing and forwarding (VRFs). Therefore, an improved lookup algorithm is desired to handle various types of end-point identifiers. The disclosed technology addresses the need in the art for address lookups in a telecommunications network. Disclosed are systems, methods, and computer-readable storage media for unifying various types of end-point identifiers by mapping end-point identifiers to a uniform space and allowing different forms of lookups to be uniformly handled. A brief introductory description of example systems and networks, as illustrated in FIGs. 3 and 4, is disclosed herein. These variations shall be described herein as the various examples are set forth. The technology now turns to FIG. 3.

FIG. 3 illustrates an example computing device 300 suitable for implementing the present technology. Computing device 300 includes a master central processing unit (CPU) 362, interfaces 368, and a bus 315 (*e.g.,* a PCI bus). When acting under the control of appropriate software or firmware, the CPU 362 is responsible for executing packet management, error detection, and/or routing functions, such as miscabling detection functions, for example. The CPU 362 preferably accomplishes all these functions under the control of software including an operating system and any appropriate applications software. CPU 362 can include one or more processors 363 such as a processor from the Motorola family of microprocessors or the MIPS family of microprocessors. In an alternative example, processor 363 is specially designed hardware for controlling the operations of the computing device 300. In a specific example, a memory 361 (such as non-volatile RAM and/or ROM) also forms part of CPU 362. However, there are many different ways in which memory could be coupled to the system.

The interfaces 368 are typically provided as interface cards (sometimes referred to as "line cards"). Generally, they control the sending and receiving of data packets over the network and sometimes support other peripherals used with the computing device 300. Among the interfaces that can be provided are Ethernet interfaces, frame relay interfaces, cable interfaces, DSL interfaces, token ring interfaces, and the like. In addition, various very high-speed interfaces can be provided such as fast token ring interfaces, wireless interfaces, Ethernet interfaces, Gigabit Ethernet interfaces, ATM interfaces, HSSI interfaces, POS interfaces, FDDI interfaces and the like. Generally, these interfaces can include ports appropriate for communication with the appropriate media. In some cases, they can also include an independent processor and, in some instances, volatile RAM. The independent processors can control such communications intensive tasks as packet switching, media control and management. By providing separate processors for the communications intensive tasks, these interfaces allow the master microprocessor 362 to efficiently perform routing computations, network diagnostics, security functions, etc.

Although the system shown in FIG. 3 is one specific computing device of the present technology, it is by no means the only network device architecture on which the present patent application can be implemented. For example, an architecture having a single processor that handles communications as well as routing computations, etc. is often used. Further, other types of interfaces and media could also be used with the router.

Regardless of the network device's configuration, it can employ one or more memories or memory modules (including memory 361) configured to store program instructions for the general-purpose network operations and mechanisms for roaming, route optimization and routing functions described herein. The program instructions can control the operation of an operating system and/or one or more applications, for example. The memory or memories can also be configured to store tables such as mobility binding, registration, and association tables, etc.

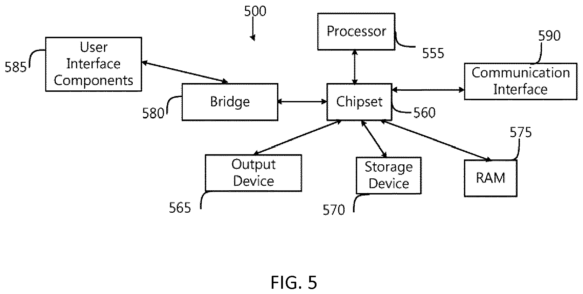

FIG. 4 and FIG. 5 illustrate example possible systems in accordance with various aspects of the present technology. The more appropriate example will be apparent to those of ordinary skill in the art when practicing the present technology. Persons of ordinary skill in the art will also readily appreciate that other system examples are possible.

FIG. 4 illustrates a conventional computing system architecture 400 wherein the components of the system are in electrical communication with each other using a bus 405. Example system 400 includes a processing unit (CPU or processor) 410 and a system bus 405 that couples various system components including the system memory 415, such as read only memory (ROM) 420 and random access memory (RAM) 425, to the processor 410. The system 400 can include a cache of high-speed memory connected directly with, in close proximity to, or integrated as part of the processor 410. The system 400 can copy data from the memory 415 and/or the storage device 430 to the cache 412 for quick access by the processor 410. In this way, the cache can provide a performance boost that avoids processor 410 delays while waiting for data. These and other modules can control or be configured to control the processor 410 to perform various actions. Other system memory 415 can be available for use as well. The memory 415 can include multiple different types of memory with different performance characteristics. The processor 410 can include any general purpose processor and a hardware module or software module, such as module 432, module 434, and module 436 stored in storage device 430, configured to control the processor 410 as well as a special-purpose processor where software instructions are incorporated into the actual processor design. The processor 410 can essentially be a completely self-contained computing system, containing multiple cores or processors, a bus, memory controller, cache, etc. A multi-core processor can be symmetric or asymmetric.

To enable user interaction with the computing device 400, an input device 445 can represent any number of input mechanisms, such as a microphone for speech, a touch-sensitive screen for gesture or graphical input, keyboard, mouse, motion input, speech and so forth. An output device 435 can also be one or more of a number of output mechanisms known to those of skill in the art. In some instances, multimodal systems can enable a user to provide multiple types of input to communicate with the computing device 400. The communications interface 440 can generally govern and manage the user input and system output. There is no restriction on operating on any particular hardware arrangement and therefore the basic features here can easily be substituted for improved hardware or firmware arrangements as they are developed. Any features or steps in any example of this patent application may be mixed with any other features or steps in any other examples.

Storage device 430 is a non-volatile memory and can be a hard disk or other types of computer readable media which can store data that are accessible by a computer, such as magnetic cassettes, flash memory cards, solid state memory devices, digital versatile disks, cartridges, random access memories (RAMs) 425, read only memory (ROM) 420, and hybrids thereof.

The storage device 430 can include software modules 432, 434, 436 for controlling the processor 410. Other hardware or software modules are contemplated. The storage device 430 can be connected to the system bus 405. In one aspect, a hardware module that performs a particular function can include the software component stored in a computer-readable medium in connection with the necessary hardware components, such as the processor 410, bus 405, output device 435 (e.g., a display), and so forth, to carry out the function.

FIG. 5 illustrates a computer system 500 having a chipset architecture that can be used in executing the described method and generating and displaying a graphical user interface (GUI). Computer system 500 is an example of computer hardware, software, and firmware that can be used to implement the disclosed technology. System 500 can include a processor 555, representative of any number of physically and/or logically distinct resources capable of executing software, firmware, and hardware configured to perform identified computations. Processor 555 can communicate with a chipset 560 that can control input to and output from processor 555. In this example, chipset 560 outputs information to output device 565, such as a display, and can read and write information to storage device 570, which can include magnetic media, and solid state media, for example. Chipset 560 can also read data from and write data to RAM 575. A bridge 580 for interfacing with a variety of user interface components 585 can be provided for interfacing with chipset 560. Such user interface components 585 can include a keyboard, a microphone, touch detection and processing circuitry, a pointing device, such as a mouse, and so on. In general, inputs to system 500 can come from any of a variety of sources, machine generated and/or human generated.

Chipset 560 can also interface with one or more communication interfaces 590 that can have different physical interfaces. Such communication interfaces can include interfaces for wired and wireless local area networks, for broadband wireless networks, as well as personal area networks. Some applications of the methods for generating, displaying, and using the GUI disclosed herein can include receiving ordered datasets over the physical interface or be generated by the machine itself by processor 555 analyzing data stored in storage 570 or RAM 575. Further, the machine can receive inputs from a user via user interface components 585 and execute appropriate functions, such as browsing functions by interpreting these inputs using processor 555.

It can be appreciated that example systems 400 and 500 can have more than one processor 410 or be part of a group or cluster of computing devices networked together to provide greater processing capability.

For clarity of explanation, in some instances the present technology can be presented as including individual functional blocks including functional blocks comprising devices, device components, steps or routines in a method embodied in software, or combinations of hardware and software.

In some examples, the computer-readable storage devices, mediums, and memories can include a cable or wireless signal containing a bit stream and the like. However, when mentioned, non-transitory computer-readable storage media expressly exclude media such as energy, carrier signals, electromagnetic waves, and signals per se.

Methods according to the above-described examples can be implemented using computer-executable instructions that are stored or otherwise available from computer readable media. Such instructions can comprise, for example, instructions and data which cause or otherwise configure a general purpose computer, special purpose computer, or special purpose processing device to perform a certain function or group of functions. Portions of computer resources used can be accessible over a network. The computer executable instructions can be, for example, binaries, intermediate format instructions such as assembly language, firmware, or source code. Examples of computer-readable media that can be used to store instructions, information used, and/or information created during methods according to described examples include magnetic or optical disks, flash memory, USB devices provided with non-volatile memory, networked storage devices, and so on.

Devices implementing methods according to these disclosures can comprise hardware, firmware and/or software, and can take any of a variety of form factors. Typical examples of such form factors include laptops, smart phones, small form factor personal computers, personal digital assistants, and so on. Functionality described herein also can be embodied in peripherals or add-in cards. Such functionality can also be implemented on a circuit board among different chips or different processes executing in a single device, by way of further example.

The instructions, media for conveying such instructions, computing resources for executing them, and other structures for supporting such computing resources are means for providing the functions described in these disclosures.

Various aspects of the present technology provide systems and methods for managing a memory module in a server system. While specific examples have been cited above showing how the optional operation can be employed in different instructions, other examples can incorporate the optional operation into different instructions. For clarity of explanation, in some instances the present technology can be presented as including individual functional blocks including functional blocks comprising devices, device components, steps or routines in a method embodied in software, or combinations of hardware and software.

The various examples can be further implemented in a wide variety of operating environments, which in some cases can include one or more server computers, user computers or computing devices which can be used to operate any of a number of applications. User or client devices can include any of a number of general purpose personal computers, such as desktop or laptop computers running a standard operating system, as well as cellular, wireless and handheld devices running mobile software and capable of supporting a number of networking and messaging protocols. Such a system can also include a number of workstations running any of a variety of commercially-available operating systems and other known applications for purposes such as development and database management. These devices can also include other electronic devices, such as dummy terminals, thin-clients, gaming systems and other devices capable of communicating via a network.

To the extent examples, or portions thereof, are implemented in hardware, the present patent application can be implemented with any or a combination of the following technologies: a discrete logic circuit(s) having logic gates for implementing logic functions upon data signals, an application specific integrated circuit (ASIC) having appropriate combinational logic gates, programmable hardware such as a programmable gate array(s) (PGA), a field programmable gate array (FPGA), etc.

Most examples utilize at least one network that would be familiar to those skilled in the art for supporting communications using any of a variety of commercially-available protocols, such as TCP/IP, OSI, FTP, UPnP, NFS, CIFS, AppleTalk etc. The network can be, for example, a local area network, a wide-area network, a virtual private network, the Internet, an intranet, an extranet, a public switched telephone network, an infrared network, a wireless network and any combination thereof.

Methods according to the above-described examples can be implemented using computer-executable instructions that are stored or otherwise available from computer readable media. Such instructions can comprise, for example, instructions and data which cause or otherwise configure a general purpose computer, special purpose computer, or special purpose processing device to perform a certain function or group of functions. Portions of computer resources used can be accessible over a network. The computer executable instructions can be, for example, binaries, intermediate format instructions such as assembly language, firmware, or source code. Examples of computer-readable media that can be used to store instructions, information used, and/or information created during methods according to described examples include magnetic or optical disks, flash memory, USB devices provided with non-volatile memory, networked storage devices, and so on.

Devices implementing methods according to these technology can comprise hardware, firmware and/or software, and can take any of a variety of form factors. Typical examples of such form factors include server computers, laptops, smart phones, small form factor personal computers, personal digital assistants, and so on. Functionality described herein also can be embodied in peripherals or add-in cards. Such functionality can also be implemented on a circuit board among different chips or different processes executing in a single device, by way of further example.

In examples utilizing a Web server, the Web server can run any of a variety of server or mid-tier applications, including HTTP servers, FTP servers, CGI servers, data servers, Java servers and business application servers. The server(s) can also be capable of executing programs or scripts in response requests from user devices, such as by executing one or more Web applications that can be implemented as one or more scripts or programs written in any programming language, such as Java®, C, C# or C++ or any scripting language, such as Perl, Python or TCL, as well as combinations thereof. The server(s) can also include database servers, including without limitation those commercially available from open market.

The server farm can include a variety of data stores and other memory and storage media as discussed above. These can reside in a variety of locations, such as on a storage medium local to (and/or resident in) one or more of the computers or remote from any or all of the computers across the network. In a particular set of examples, the information can reside in a storage-area network (SAN) familiar to those skilled in the art. Similarly, any necessary files for performing the functions attributed to the computers, servers or other network devices can be stored locally and/or remotely, as appropriate. Where a system includes computerized devices, each such device can include hardware elements that can be electrically coupled via a bus, the elements including, for example, at least one central processing unit (CPU), at least one input device (e.g., a mouse, keyboard, controller, touch-sensitive display element or keypad) and at least one output device (e.g., a display device, printer or speaker). Such a system can also include one or more storage devices, such as disk drives, optical storage devices and solid-state storage devices such as random access memory (RAM) or read-only memory (ROM), as well as removable media devices, memory cards, flash cards, etc.

Such devices can also include a computer-readable storage media reader, a communications device (e.g., a modem, a network card (wireless or wired), an infrared computing device) and working memory as described above. The computer-readable storage media reader can be connected with, or configured to receive, a computer-readable storage medium representing remote, local, fixed and/or removable storage devices as well as storage media for temporarily and/or more permanently containing, storing, transmitting and retrieving computer-readable information. The system and various devices also typically will include a number of software applications, modules, services or other elements located within at least one working memory device, including an operating system and application programs such as a client application or Web browser. It should be appreciated that alternate examples can have numerous variations from that described above. For example, customized hardware might also be used and/or particular elements might be implemented in hardware, software (including portable software, such as applets) or both. Further, connection to other computing devices such as network input/output devices can be employed.

Storage media and computer readable media for containing code, or portions of code, can include any appropriate media known or used in the art, including storage media and computing media, such as but not limited to volatile and non-volatile, removable and non-removable media implemented in any method or technology for storage and/or transmission of information such as computer readable instructions, data structures, program modules or other data, including RAM, ROM, EPROM, EEPROM, flash memory or other memory technology, CD-ROM, digital versatile disk (DVD) or other optical storage, magnetic cassettes, magnetic tape, magnetic disk storage or other magnetic storage devices or any other medium which can be used to store the desired information and which can be accessed by a system device. Based on the technology and teachings provided herein, a person of ordinary skill in the art will appreciate other ways and/or methods to implement the various aspects of the present technology.

The specification and drawings are, accordingly, to be regarded in an illustrative rather than a restrictive sense. It will, however, be evident that various modifications and changes can be made thereunto without departing from the scope of the patent application as set forth in the claims.

## Claims

1. A computer-implemented method of a post package repair, PPR, in a server system (100C, 101, 102), comprising:
receiving, from a specific storage of the server system (100C, 101, 102), a PPR status of a memory module of the server system (100C, 101, 102), the memory module supporting the PPR;
receiving a plurality of PPR variables from the specific storage;
determining that there is a memory error in the memory module to be fixed;
determining, based at least upon the PPR status of the memory module and the plurality of PPR variables, that a plurality of bank groups of the memory module has at least one spare row;
repairing the memory error using the at least one spare row of the plurality of bank groups; and
updating the PPR status stored in the specific storage of the server system (100C, 101, 102);
**characterized in that**:
wherein when determining that there is no spare row in the plurality of bank groups, a BIOS skips the PPR repair, and logs physical location address(es) of the memory error in a memory mask table;
wherein the memory module is a dual in-line memory module, DIMM, including non-serial presence detect, SPD, regions;
wherein a PPR status table of the PPR status is generated after determining that there is a checksum error or the PPR status table does not exist, which includes:
determining a count of the plurality of bank groups of the DIMM based at least upon information collected from the non-SPD regions of the DIMM; and
generating the PPR status table based at least upon the count of the plurality of bank groups and the PPR variables.

2. The computer-implemented method of claim 1, wherein the DIMM is a double data rate, DDR, fourth generation synchronous dynamic random-access memory, SDRAM, module.

3. The computer-implemented method of claim 2, wherein the specific storage is a DDR4 SPD module, a BIOS variable module, or a controller (112) of the server system (100C, 101, 102), and preferably the specific storage is a one or more "End User Programmable" regions of the DDR4 SPD module; and
wherein the specific storage is capable of operating independently from the BIOS (1016, 1026) or the controller (112) of the server system (100C, 101, 102).

4. The computer-implemented method of claim 3, wherein after determining that there is the checksum error or the PPR status table does not exist, further comprising:
writing the PPR status table to the SPD module; and
wherein the PPR status table comprises a "Signature" field for identification, a "Length" field for describing a total size of the PPR status table, and a "Checksum" field for checking whether data of the PPR status table is correct or not.

5. The computer-implemented method of any one of the preceding claims, wherein the PPR status comprises a status of a first subset of the plurality of bank groups and a second subset of the plurality of bank groups, any bank group in the first subset of the plurality of bank groups having at least one spare row, no bank group in the second subset of the plurality of bank groups having a spare row.

6. The computer-implemented method of claim 5, further comprising:
masking the physical location address(es) of the memory error during a subsequent POST based at least upon the memory mask table in response to determining that there is no spare row in the plurality of bank groups.

7. A server system (100C, 101, 102), comprising:
a processor (1012, 1022, 363, 410, 555); and
a computer-readable medium storing instructions that, when executed by the processor (1012, 1022, 363, 410, 555), cause the server system (100C, 101, 102) to perform operations comprising:
receiving, from a specific storage of the server system (100C, 101, 102), a post package repair, PPR, status of a memory module of the server system (100C, 101, 102), the memory module supporting a PPR;
receiving a plurality of PPR variables from the specific storage;
determining that there is a memory error in the memory module to be fixed;
determining, based at least upon the PPR status of the memory module and the plurality of PPR variables, that a plurality of bank groups of the memory module has at least one spare row;
repairing the memory error using the at least one spare row of the plurality of bank groups; and
updating the PPR status stored in the specific storage of the server system (100C, 101, 102);
**characterized in that**:
wherein when determining that there is no spare row in the plurality of bank groups, a BIOS skips the PPR repair, and logs physical location address(es) of the memory error in a memory mask table;
wherein the memory module is a dual in-line memory module, DIMM, including non-serial presence detect, SPD, regions;
wherein a PPR status table of the PPR status is generated after determining that there is a checksum error or the PPR status table does not exist, which includes:
determining a count of the plurality of bank groups of the DIMM based at least upon information collected from the non- SPD regions of the DIMM; and
generating the PPR status table based at least upon the count of the plurality of bank groups and the PPR variables.

8. The server system (100C, 101, 102) of claim 7, wherein the DIMM is a double data rate, DDR, fourth generation synchronous dynamic random-access memory, SDRAM, module.

9. The server system (100C, 101, 102) of claim 8, wherein the specific storage is a DDR4 SPD module, a BIOS variable module, or a controller (112) of the server system (100C, 101, 102), and preferably the specific storage is a one or more "End User Programmable" regions of the DDR4 SPD module; and
wherein the specific storage is capable of operating independently from a BIOS (1016, 1026) or the controller (112) of the server system (100C, 101, 102).

10. The server system (100C, 101, 102) of claim 9, wherein after determining that there is the checksum error or the PPR status table does not exist, the instructions, when executed by the processor (1012, 1022, 363, 410, 555), cause the server system (100C, 101, 102) to perform operations comprising:
writing the PPR status table to the SPD module.

11. The server system (100C, 101, 102) of claim 10, wherein the PPR status table comprises a "Signature" field for identification, a "Length" field for describing a total size of the PPR status table, and a "Checksum" field for checking whether data of the PPR status table is correct or not.

12. The server system (100C, 101, 102) of claims 7 to 11, wherein the PPR status comprises a status of a first subset of the plurality of bank groups and a second subset of the plurality of bank groups, any bank group in the first subset of the plurality of bank groups having at least one spare row, no bank group in the second subset of the plurality of bank groups having a spare row.

## Patentansprüche

1. Computerimplementiertes PPR-, Post Package Repair, Verfahren in einem Serversystem (100C, 101, 102), mit den Schritten:
Empfangen eines PPR-Status eines Speichermoduls des Serversystems (100C, 101, 102) von einem spezifischen Speicher des Serversystems (100C, 101, 102), wobei das Speichermodul PPR unterstützt;
Empfangen mehrerer PPR-Variablen vom spezifischen Speicher;
Bestimmen, dass ein Speicherfehler in dem Speichermodul repariert werden soll;
Bestimmen, basierend mindestens auf dem PPR-Status des Speichermoduls und den mehreren PPR-Variablen, dass mehrere Bankgruppen des Speichermoduls zumindest eine Spare Row aufweisen;
Reparieren des Speicherfehlers unter Verwendung der mindestens einen Spare Row der mehreren Bankgruppen; und
Aktualisieren des in dem spezifischen Speicher des Serversystems (100C, 101, 102) gespeicherten PPR-Status;
**dadurch gekennzeichnet, dass**:
wenn bestimmt wird, dass keine Spare Row in den mehreren Bankgruppen vorhanden ist, ein BIOS die PPR-Reparatur überspringt und eine physikalische Ortsadresse (physikalische Ortsadressen) des Speicherfehlers in einer Speichermaskentabelle protokolliert,
wobei das Speichermodul ein Dual-In-Line-Speichermodul (DIMM) mit Non-SPD-, Non-Serial Presence Detect, Bereichen ist,
wobei eine PPR-Statustabelle des PPR-Status erzeugt wird, nachdem bestimmt wurde, dass ein Prüfsummenfehler vorliegt oder die PPR-Statustabelle nicht existiert, was beinhaltet:
Bestimmen eines Zählwerts der mehreren Bankgruppen des DIMM mindestens auf Information, die von den Non-SPD-Bereichen des DIMM gesammelt wird; und
Erzeugen der PPR-Statustabelle mindestens basierend auf dem Zählwert der mehreren Bankgruppen und der PPR-Variablen.

2. Computerimplementiertes Verfahren nach Anspruch 1, wobei das DIMM ein DDR-, Double Data Rate, SDRAM, Synchronous Dynamic Random-Access Memory, der vierten Generation ist.

3. Computerimplementiertes Verfahren nach Anspruch 2, wobei der spezifische Speicher ein DDR4-SPD-Modul, ein BIOS-Variable-Modul oder eine Steuereinheit (112) des Serversystems (100C, 101, 102) ist, und wobei vorzugsweise der spezifische Speicher ein oder mehrere "durch einen Endbenutzer programmierbare" Bereiche des DDR4-SPD-Moduls ist, und
wobei der spezifische Speicher in der Lage ist, unabhängig von dem BIOS (1016, 1026) oder von der Steuereinheit (112) des Serversystems (100C, 101, 102) zu arbeiten.

4. Computerimplementiertes Verfahren nach Anspruch 3, wobei nach dem Bestimmen, dass der Prüfsummenfehler vorliegt oder die PPR-Statustabelle nicht existiert, ferner der Schritt ausgeführt wird:
Schreiben der PPR-Statustabelle in das SPD-Modul,
wobei die PPR-Statustabelle ein "Signatur"-Feld zur Identifizierung, ein "Länge"-Feld zum Beschreiben einer Gesamtgröße der PPR-Statustabelle und ein "Prüfsummen"-Feld zum Prüfen aufweist, ob Daten der PPR-Statustabelle korrekt sind oder nicht.

5. Computerimplementiertes Verfahren nach einem der vorhergehenden Ansprüche, wobei der PPR-Status einen Status eines ersten Teilsatzes der mehreren Bankgruppen und eines zweiten Teilsatzes der mehreren Bankgruppen aufweist, wobei eine beliebige Bankgruppe im ersten Teilsatz der mehreren Bankgruppen mindestens eine Spare Row aufweist und keine Bankgruppe im zweiten Teilsatz der mehreren Bankgruppen eine Spare Row aufweist.

6. Computerimplementiertes Verfahren nach Anspruch 5, ferner mit dem Schritt zum Maskieren der physikalischen Ortsadresse(n) des Speicherfehlers während eines nachfolgenden POST basierend mindestens auf der Speichermaskentabelle in Antwort auf das Bestimmen, dass keine Spare Row in den mehreren Bankgruppen vorhanden ist.

7. Serversystem (100C, 101, 102), mit:
einem Prozessor (1012, 1022, 363, 410, 555); und
einem computerlesbaren Medium, das Anweisungen speichert, die, wenn sie durch den Prozessor (1012, 1022, 363, 410, 555) ausgeführt werden, das Serversystem (100C, 101, 102) veranlassen, Operationen auszuführen, die die Schritte aufweisen:
Empfangen eines PPR-, Post Package Repair, Status eines Speichermoduls des Serversystems (100C, 101, 102) von einem spezifischen Speicher des Serversystems (100C, 101, 102), wobei das Speichermodul PPR unterstützt;
Empfangen mehrerer PPR-Variablen von dem spezifischen Speicher;
Bestimmen, dass ein Speicherfehler in dem zu reparierenden Speichermodul vorliegt;
Bestimmen, basierend mindestens auf dem PPR-Status des Speichermoduls und den mehreren PPR-Variablen, dass mehrere Bankgruppen des Speichermoduls zumindest eine Spare Row aufweisen;
Reparieren des Speicherfehlers unter Verwendung der mindestens einen Spare Row der mehreren Bankgruppen; und
Aktualisieren des in dem spezifischen Speicher des Serversystems (100C, 101, 102) gespeicherten PPR-Status;
**dadurch gekennzeichnet, dass**:
wenn bestimmt wird, dass keine Spare Row in den mehreren Bankgruppen vorhanden ist, ein BIOS die PPR-Reparatur überspringt und eine physikalische Ortadresse (physikalische Ortsadressen) des Speicherfehlers in einer Speichermaskentabelle protokolliert,
wobei das Speichermodul ein Dual-In-Line-Speichermodul (DIMM) mit Non-SPD-, Non-serial Presence Detect, Bereichen ist,
wobei eine PPR-Statustabelle des PPR-Status erzeugt wird, nachdem bestimmt wurde, dass ein Prüfsummenfehler vorliegt oder die PPR-Statustabelle nicht existiert, was beinhaltet:
Bestimmen eines Zählwerts der mehreren Bankgruppen des DIMM mindestens auf Information, die von den Non-SPD-Bereichen des DIMM gesammelt wird; und
Erzeugen der PPR-Statustabelle mindestens basierend auf dem Zählwert der mehreren Bankgruppen und der PPR-Variablen.

8. Serversystem (100C, 101, 102) nach Anspruch 7, wobei das DIMM ein DDR-, Double Data Rate, SDRAM, Synchronous Dynamic Random-Access Memory, der vierten Generation ist.

9. Serversystem (100C, 101, 102) nach Anspruch 8, wobei der spezifische Speicher ein DDR4-SPD-Modul, ein BIOS-Variable-Modul oder eine Steuereinheit (112) des Serversystems (100C, 101, 102) ist, und wobei vorzugsweise der spezifische Speicher ein oder mehrere "durch einen Endbenutzer programmierbare" Bereiche des DDR4-SPD-Moduls ist, und
wobei der spezifische Speicher in der Lage ist, unabhängig von dem BIOS (1016, 1026) oder von der Steuereinheit (112) des Serversystems (100C, 101, 102) zu arbeiten.

10. Serversystem (100C, 101, 102) nach Anspruch 9, wobei nach dem Bestimmen, dass der Prüfsummenfehler vorliegt oder die PPR-Statustabelle nicht existiert, die Anweisungen, wenn sie durch den Prozessor (1012, 1022, 363, 410, 555) ausgeführt werden, das Serversystem (100C, 101, 102) veranlassen, Operationen auszuführen, die den Schritt aufweisen:
Schreiben der PPR-Statustabelle in das SPD-Modul.

11. Serversystem (100C, 101, 102) nach Anspruch 10, wobei die PPR-Statustabelle ein "Signatur"-Feld zum Identifizieren eines "Länge"-Feldes zum Beschreiben einer Gesamtgröße der PPR-Statustabelle und ein "Prüfsumme"-Feld zum Prüfen aufweist, ob Daten der PPR-Statustabelle korrekt sind oder nicht.

12. Serversystem (100C, 101, 102) nach einem der Ansprüche 7 bis 11, wobei der PPR-Status einen Status eines ersten Teilsatzes der mehreren Bankgruppen und eines zweiten Teilsatzes der mehreren Bankgruppen aufweist, wobei eine beliebige Bankgruppe im ersten Teilsatz der mehreren Bankgruppen mindestens eine Spare Row aufweist und keine Bankgruppe im zweiten Teilsatz der mehreren Bankgruppen eine Spare Row aufweist.

## Revendications

1. Procédé mis en œuvre par ordinateur d'une réparation post-conditionnement, PPR, dans un système serveur (100C, 101, 102), comprenant :
la réception, en provenance d'un stockage spécifique du système serveur (100C, 101, 102) d'un statut de PPR d'un module de mémoire du système serveur (100C, 101, 102), le module de mémoire supportant la PPR ;
la réception d'une pluralité de variables de PPR en provenance du stockage spécifique ;
la détermination qu'il existe une erreur de mémoire dans le module de mémoire à réparer ;
la détermination, sur la base au moins du statut de PPR du module de mémoire et de la pluralité des variables de PPR qu'une pluralité de groupes de banque du module de mémoire a au moins une rangée de rechange ;
la réparation de l'erreur de mémoire en utilisant l'au moins une rangée de rechange de la pluralité des groupes de banque ; et
la mise à jour du statut de la PPR stocké dans le stockage spécifique du système serveur (100C, 101, 102) ;
**caractérisé en ce que** :
où, lors de la détermination qu'il n'y a pas de rangée de rechange dans la pluralité des groupes de banque, un BIOS laisse tomber la réparation PPR et enregistre une (des) adresse(s) de localisation physique de l'erreur de mémoire dans une table de masque de mémoire ;
où le module de mémoire est un module de mémoire en lignes doubles, DIMM, comportant des régions de détection de présence non série, SPD ;
où une table de statut de PPR du statut de la PPR est générée après la détermination qu'il y a une erreur de total de contrôle, ou que la table de statut de PPR n'existe pas, qui comporte :
la détermination d'un comptage de la pluralité de groupes de banque du DIMM sur la base d'au moins une information collectée à partir des régions de non SPD du DIMM ; et
la génération de la table de statut de PPR sur la base au moins du comptage de la pluralité de groupes de banque et des variables de PPR.

2. Procédé mis en œuvre par ordinateur selon la revendication 1, dans lequel le DIMM est un module à double débit de données, DDR, à mémoire synchrone dynamique à accès aléatoire, SDRAM, de quatrième génération.

3. Procédé mis en œuvre par ordinateur selon la revendication 2, dans lequel le stockage spécifique est un module DDR4 SPD, un module variable de BIOS, ou un dispositif de commande (112) du système serveur (100C, 101, 102) et de préférence le stockage spécifique est une ou plusieurs régions « programmables par l'utilisateur final » du module DDR4 SPD ; et
dans lequel le stockage spécifique est capable de fonctionner indépendamment du BIOS (1016, 1026) ou du dispositif de commande (112) du système serveur (100C, 101, 102).

4. Procédé mis en œuvre par ordinateur selon la revendication 3, dans lequel, après la détermination qu'il existe une erreur de total de contrôle ou que la table de statut de la PPR n'existe pas, comprend en outre :
l'écriture de la table de statut de la PPR au niveau du module SPD ; et
où la table de statut de PPR comprend un champ de « signature » pour l'identification, un champ de « longueur » pour la description d'une taille totale de la table de statut de PPR, et un champ de « total de contrôle » pour la vérification que les données de la table de statut de PPR sont correctes ou non.

5. Procédé mis en œuvre par ordinateur selon l'une quelconque des revendications précédentes, dans lequel le statut de PPR comprend un statut d'un premier sous-ensemble de la pluralité des groupes de banque et un second sous-ensemble de la pluralité des groupes de banque, un groupe de banque quelconque dans le premier sous-ensemble de la pluralité des groupes de banque ayant au moins une rangée de rechange, aucun groupe de banque dans le second sous-ensemble de la pluralité des groupes de banque n'ayant de rangée de rechange.

6. Procédé mis en œuvre par ordinateur selon la revendication 5, comprenant en outre :
le masquage de l'adresse (des adresses) de localisation physique de l'erreur de mémoire durant une POST ultérieure sur la base au moins de la table de masque de mémoire en réponse à la détermination qu'il n'y a pas de rangée de rechange dans la pluralité des groupes de banque.

7. Système serveur (100C, 101, 102) comprenant :
un processeur (1012, 1022, 363, 410, 555) ; et
un support lisible par ordinateur stockant des instructions, qui, lorsqu'elles sont exécutées par le processeur (1012, 1022, 363, 410, 555), font en sorte que le système serveur (100C, 101, 102) effectue des opérations comprenant :
la réception, en provenance d'un stockage spécifique du système serveur (100C, 101, 102) d'un statut de réparation post-conditionnement, PPR, d'un module de mémoire du système serveur (100C, 101, 102), le module de mémoire supportant une PPR ;
la réception d'une pluralité de variables de PPR en provenance du stockage spécifique ;
la détermination qu'il existe une erreur de mémoire dans le module de mémoire à réparer ;
la détermination, sur la base au moins du statut de PPR du module de mémoire et de la pluralité des variables de PPR qu'une pluralité de groupes de banque du module de mémoire a au moins une rangée de rechange ;
la réparation de l'erreur de mémoire en utilisant l'au moins une rangée de rechange de la pluralité des groupes de banque ; et
la mise à jour du statut de la PPR stocké dans le stockage spécifique du système serveur (100C, 101, 102) ;
**caractérisé en ce que** :
où, lors de la détermination qu'il n'y a pas de rangée de rechange dans la pluralité des groupes de banque, un BIOS laisse tomber la réparation PPR et enregistre une (des) adresse(s) de localisation physique de l'erreur de mémoire dans une table de masque de mémoire ;
où le module de mémoire est un module de mémoire en lignes doubles, DIMM, comportant des régions de détection de présence non série, SPD ;
où une table de statut de PPR du statut de la PPR est générée après la détermination qu'il y a une erreur de total de contrôle, ou que la table de statut PPR n'existe pas, qui comporte :
la détermination d'un comptage de la pluralité de groupes de banque du DIMM sur la base d'au moins une information collectée à partir des régions de non SPD du DIMM ; et
la génération de la table de statut de PPR sur la base au moins du comptage de la pluralité de groupes de banque et des variables de PPR.

8. Système serveur (100C, 101, 102) selon la revendication 7, dans lequel le DIMM est un module à double débit de données, DDR, à mémoire synchrone dynamique à accès aléatoire, SDRAM, de quatrième génération.

9. Système serveur (100C, 101, 102) selon la revendication 8, dans lequel le stockage spécifique est un module DDR4 SPD, un module variable de BIOS, ou un dispositif de commande (112) du système serveur (100C, 101, 102) et de préférence le stockage spécifique est une ou plusieurs régions « programmables par l'utilisateur final » du module DDR4 SPD ; et
dans lequel le stockage spécifique est capable de fonctionner indépendamment d'un BIOS (1016, 1026) ou du dispositif de commande (112) du système serveur (100C, 101, 102).

10. Système serveur (100C, 101, 102) selon la revendication 9, dans lequel, après la détermination qu'il existe une erreur de total de contrôle ou que la table de statut de la PPR n'existe pas, les instructions, lorsqu'elles sont exécutées par le processeur (1012, 1022, 363, 410, 55), font en sorte que le système serveur (100C, 101, 102) exécute des opérations comprenant :
l'écriture de la table de statut de la PPR au niveau du module SPD.

11. Système serveur (100C, 101, 102) selon la revendication 10, dans lequel la table de statut de PPR comprend un champ de « signature » pour l'identification, un champ de « longueur » pour la description d'une taille totale de la table de statut de PPR, et un champ de « total de contrôle » pour la vérification si les données de la table de statut de PPR sont correctes ou non.

12. Système serveur (100C, 101, 102) selon les revendications 7 à 11, dans lequel le statut de PPR comprend un statut d'un premier sous-ensemble de la pluralité des groupes de banque et un second sous-ensemble de la pluralité des groupes de banque, un groupe de banque quelconque dans le premier sous-ensemble de la pluralité des groupes de banque ayant au moins une rangée de rechange, aucun groupe de banque dans le second sous-ensemble de la pluralité des groupes de banque n'ayant de rangée de rechange.
